# FASCICULE DE BREVET EUROPEEN

(11) **EP 3 340 303 B1**
(45) Date de publication et mention de la délivrance du brevet: **11.09.2019**
(21) Numéro de dépôt: 17207777.8
(22) Date de dépôt: 15.12.2017
(51) Int. Cl.: H01L 27/146

(54) **MODULE OPTOELECTRONIQUE 3D D'IMAGERIE**
OPTOELEKTRONISCHES MODUL ZUR 3D-BILDANZEIGE
IMAGING 3D OPTO-ELECTRONIC MODULE

(30) Priorité: 20.12.2016 FR 1662823
(43) Date de publication de la demande: 27.06.2018
(73) Titulaire: 3D Plus, 78530 Buc (FR)
(72) Inventeur: GAMBART, Didier, 78220 VIROFLAY (FR)
(74) Mandataire: Henriot, Marie-Pierre

(56) Documents cités:
- JP-A- 2001 188 155
- US-A1- 2008 192 435
- US-A1- 2014 240 588

## Description

Le domaine de l'invention est celui des modules optoélectroniques 3D d'imagerie et plus particulièrement d'imagerie spatiale, utilisés pour la prise d'image photo ou vidéo dans toutes les longueurs d'ondes par exemple pour des missions de planétologie, d'exploration de planètes, de viseur d'étoile ou de la surveillance de satellite ou de lanceur.

Le document JP 2001 188155 décrit un module optoélectronique pour prise d'image.

Il est connu que dans l'industrie spatiale il est souhaitable de miniaturiser les modules optoélectroniques 3D d'imagerie tout en utilisant des capteurs optoélectroniques plus grands ayant une plus grande résolution, et en réduisant le cout du dispositif.

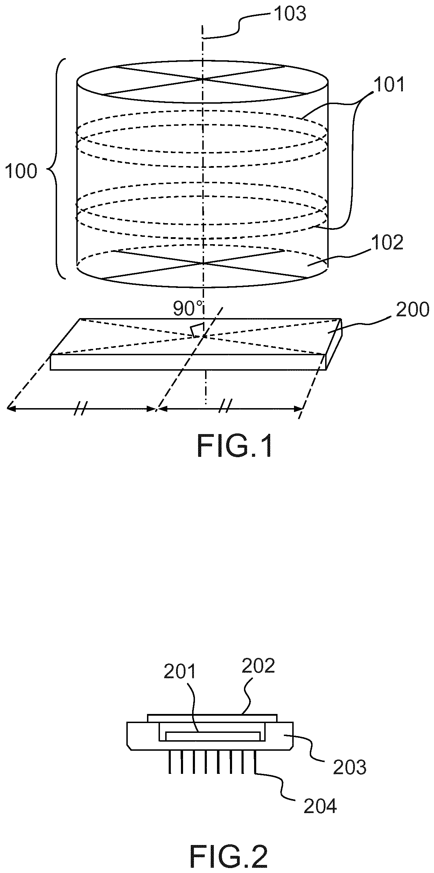

La figure 1 présente une conception classique d'un dispositif optoélectronique utilisé en imagerie spatiale. Il comporte disposés selon un axe optique 103 :
- un dispositif optique de formation d'image 100 avec des lentilles 101 et un objectif 102 et
- un capteur photosensible 200.

On montre plus en détail figure 2 un capteur optoélectronique photosensible 200. Il comprend une partie active 201 telle qu'une puce en silicium collée dans un boitier 203 par exemple en céramique qui est le matériau généralement utilisé pour les applications spatiales. Le plan de référence du capteur est dans la plupart des cas la face arrière du boîtier 203. Des connexions électriques 204 sous forme de broches PGA (Pin Grid Array) permettent d'assurer la connexion entre la puce et l'extérieur du boîtier tel qu'un circuit PCB (Printed Circuit Board). Le boîtier est recouvert d'une vitre 202 collée sur le boitier 203.

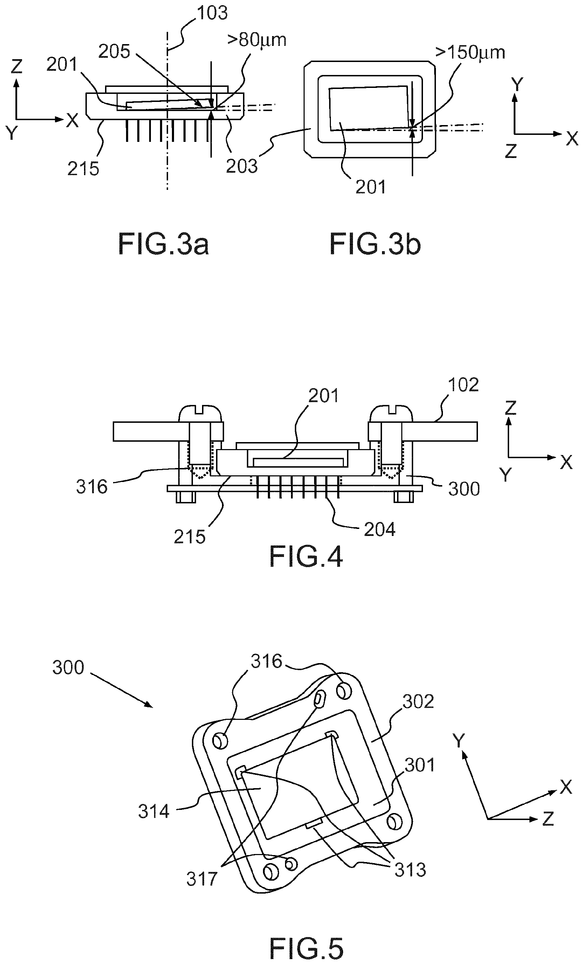

L'objectif 102 doit être parfaitement aligné avec la puce 201 ; il doit être perpendiculaire à la surface active de la puce et centré sur cette surface active. Les précisions de centrage demandées sont de l'ordre de 35 µm. Cette étape de centrage est faite manuellement et est suivie de phases de mesures optiques. Cette étape est longue et délicate et nécessite un outillage spécifique et un personnel qualifié. Il est difficile de centrer très précisément l'objectif sur la puce car elle n'est elle-même pas très bien centrée dans son boitier. On montre figure 3 un aperçu des imprécisions de positionnement apparaissant lors de l'étape de collage de la puce dans son boîtier. La puce 201 peut être décalée dans le plan XY comme illustré figure 3b et/ou présenter une erreur de perpendicularité par rapport à l'axe optique 103 en raison par exemple d'une épaisseur variable de colle 205 comme illustré figure 3a. Des erreurs de 150 µm et 80 µm, voire plus sont couramment constatées. Une fois le capteur 200 fabriqué, la puce 201 n'est plus accessible et son positionnement ne peut plus être rectifié. Il en résulte que la précision de positionnement de la puce photosensible ne respecte pas la précision finale souhaitée.

Une des problématiques pour une utilisation spatiale est aussi le maintien du capteur à une température basse. Les performances d'un capteur optique se dégradent très vite lorsque la température augmente. C'est principalement le courant d'obscurité qui augmente et dans les faits le noir devient gris ce qui est gênant dans des applications spatiales pour lesquelles le noir est prédominant sur la majorité des images. Cette problématique est amplifiée par l'utilisation de capteurs ayant de plus en plus de résolution et dissipant donc plus de puissance.

Les solutions utilisées actuellement pour refroidir les capteurs sont l'addition d'un échangeur thermique Pelletier et d'un radiateur pour dissiper et transmettre les calories. Au-delà du cout élevé de cet échangeur+radiateur, sa mise en oeuvre est délicate car la surface d'échange de la puce est sa face inférieure par laquelle elle est collée. De plus, compte tenu de l'encombrement de cet ensemble, le circuit imprimé auquel est raccordé le capteur, est déporté, ce qui présente des inconvénients. En effet, l'éloignement entre le capteur et les composants électroniques du circuit imprimé induisent des bruits électroniques.

Le but de l'invention est de pallier ces inconvénients. En conséquence, il demeure à ce jour un besoin pour un module optoélectronique 3D d'imagerie donnant simultanément satisfaction à l'ensemble des exigences précitées, en termes de dimensions, de coût, de précision de centrage et d'alignement et de température de fonctionnement.

Plus précisément l'invention a pour objet un module optoélectronique 3D d'imagerie destiné à être fixé à un dispositif de formation d'images, et qui comprend :
- un capteur optoélectronique comportant un boîtier dans lequel est logée une puce photosensible à face active plane, avec sur la face opposée des broches de connexion électrique connectées à
- un empilement d'au moins un circuit imprimé équipé de composants électroniques,
- l'ensemble capteur et empilement étant moulé dans une résine et présentant des faces verticales selon Z métallisées et gravées pour former des pistes d'interconnexion électrique des circuits imprimés.

Il est principalement caractérisé en ce qu'il comprend un berceau rigide thermiquement conducteur sous forme d'un cadre délimitant une ouverture en son centre à travers laquelle passent lesdites broches, le cadre présentant une surface de référence selon X,Y et :
∘ sur une surface supérieure :
   des points de référence de fixation destinés à centrer et aligner le dispositif de formation d'images par rapport à la surface de référence,
   des points de fixation destinés à permettre la fixation du dispositif de formation d'images, et
∘ une surface d'appui intérieure présentant des points d'appui du capteur ajustés pour que la face active de la puce soit centrée et alignée par rapport à la surface de référence.

L'ajout de ce berceau assure à la fois le maintien mécanique, l'alignement optique, la connexion électrique et la dissipation thermique. Grâce à cette unique pièce le berceau, on respecte les multiples contraintes d'utilisation d'un capteur optique dans le domaine spatial notamment. Le berceau est une pièce facile à fabriquer, de cout faible et facile à mettre en oeuvre. Comme on le verra par la suite, une seule opération suffit pour le positionnement et le collage du capteur.

La surface de référence est par exemple la surface supérieure.

La surface d'appui intérieure est de préférence colinéaire de la surface supérieure.

Le capteur optoélectronique est typiquement celui d'une caméra.

L'invention a aussi pour objet un procédé de fabrication d'un module optoélectronique 3D d'imagerie tel que décrit, caractérisé en ce qu'il comporte les étapes suivantes :
- positionnement du capteur optoélectronique sur la surface d'appui intérieure de manière à aligner et centrer la face active de la puce par rapport à la surface de référence au moyen des points de centrage de la puce,
- fixation du capteur positionné, par collage,
- assemblage de l'ensemble capteur+cadre à l'empilement de circuits imprimés,
- moulage de l'empilement et du cadre dans de la résine sans dépasser la surface supérieure du cadre,
- découpe selon des axes de découpe selon Z pour obtenir des faces latérales,
- métallisation et gravure des faces latérales pour interconnecter électriquement les circuits imprimés.

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite représente schématiquement un dispositif optoélectronique d'imagerie selon l'état de la technique,
la figure 2 déjà décrite représente schématiquement un exemple de capteur optoélectronique selon l'état de la technique, vu en coupe,
les figures 3 illustrent des erreurs de positionnement de la puce dans son plan (vu de dessus fig 3b) et par rapport à l'axe optique (vu en coupe fig 3a),
la figure 4 représente schématiquement un exemple d'éléments utilisés dans un module optoélectronique 3D d'imagerie selon l'invention, vus en coupe,
la figure 5 représente schématiquement un exemple de cadre utilisé dans un module optoélectronique 3D d'imagerie selon l'invention, en perspective,
la figure 6 représente schématiquement un exemple de cadre avec une interface thermique, prêt à recevoir un capteur,
les figures 7 illustrent schématiquement des étapes de fabrication d'un module optoélectronique 3D d'imagerie selon l'invention, la figure 7a illustrant l'étape de moulage dans de la résine de l'ensemble capteur+berceau+empilement, la figure 7b illustrant l'étape de découpe de l'ensemble moulé,
la figure 8 représente schématiquement un exemple de module optoélectronique 3D d'imagerie selon l'invention vu en perspective.

D'une figure à l'autre, les mêmes éléments sont repérés par les mêmes références.

Dans la suite de la description, les expressions « avant », « arrière », « supérieur », « inférieur » sont utilisées en référence à l'orientation des figures décrites. Dans la mesure où les éléments peuvent être positionnés selon d'autres orientations, la terminologie directionnelle est indiquée à titre d'illustration et n'est pas limitative.

On décrit en relation avec les figures 4 et 5 un exemple d'éléments inclus dans un module optoélectronique 3D d'imagerie selon l'invention. Il comporte un berceau sous forme d'un cadre rigide 300 dans lequel le capteur 200 est positionné et collé par sa face arrière 215. L'ouverture 314 du cadre est prévue pour permettre le passage des connections électriques 204. Elle est généralement rectangulaire mais pas nécessairement.

Ce cadre 300 est usiné dans la masse avec deux plans qui sont :
- le plan de pose 301 pour le collage du capteur et
- le plan de la face supérieure 302.

L'un de ces deux plans est un plan de référence. Dans la suite de la description on considère qu'il s'agit du plan de la face supérieure 302.

Le cadre 300 comporte :
- dans le plan de pose 301, des points d'appui 313 du capteur (de préférence trois points d'appui) utilisés pour aligner la puce 201 par rapport au plan de référence du cadre, dans les 3 axes,
- sur sa face supérieure 302, des points de référence 317 de fixation de l'objectif 102 destinés à centrer et aligner l'axe optique de l'objectif par rapport plan de référence du cadre. Dans notre exemple deux points de référence sont utilisés, un oblong et l'autre rond ; on peut bien sûr utiliser un ou plusieurs autres points de référence,
- sur sa face supérieure 302, des taraudages 316 ou autres moyens équivalents destinés à coopérer avec des moyens de fixation de l'objectif 102 sur le cadre.

Le contour du cadre est parallépipédique avec éventuellement sur l'extérieur des cintrages comme dans l'exemple de la figure 5 avec deux côtés cintrés. Le contour interne du cadre a une forme correspondant à celle du capteur.

L'étape de collage du capteur 200 dans le cadre 300 est réalisée par une machine de positionnement de type « pick and place » par exemple. La machine dépose une colle sur la surface de collage 301 du cadre (= surface d'appui du capteur), puis positionne le capteur 200 dans le cadre sur cette surface, réalise ensuite l'alignement optique de la puce 201 par rapport au cadre (c'est-à-dire par rapport au plan de référence) en ajustant la position du capteur dans les 3 axes grâce aux points d'appui 313. Cet alignement permet de corriger l'erreur de perpendicularité de la puce 201 par rapport au plan de référence, ainsi que le décalage dans le plan de pose, c'est-à-dire les erreurs illustrées figure 3a et 3b. La machine maintient l'ensemble (capteur+cadre) en position durant la polymérisation de la colle. La colle est typiquement une résine époxy avec ou sans charges. Cette étape est réalisée en une seule fois et dispense de toutes les opérations de réglages ultérieures. Après collage du capteur, la face sensible de la puce 201 (= face opposée aux broches de connexion) est donc colinéaire du plan de référence, en l'occurrence de la face supérieure 302 du cadre.

On obtient ainsi une précision de positionnement dans le plan de pose, typiquement de l'ordre de 35µm.

Le capteur étant ainsi fixé au cadre, l'objectif 102 d'un dispositif de formation d'images pourra être fixé au cadre 300 grâce aux points 317 de référence de fixation et aux taraudages 316 sur la face supérieure du cadre comme on peut le voir figures 4 et 5. A l'issue de ces deux étapes (collage du capteur et fixation de l'objectif), on sera assuré que :
- la face photosensible de la puce est colinéaire du plan de référence du cadre et centrée, et que
- l'axe optique de l'objectif est perpendiculaire au plan de référence du cadre et que l'objectif est centré.

Les mêmes étapes s'appliquent en considérant le plan de pose 301 comme plan de référence.

Le plan de pose et celui de la face supérieure sont avantageusement colinéaires par construction.

La puce 201 peut comporter 4 millions de pixels.

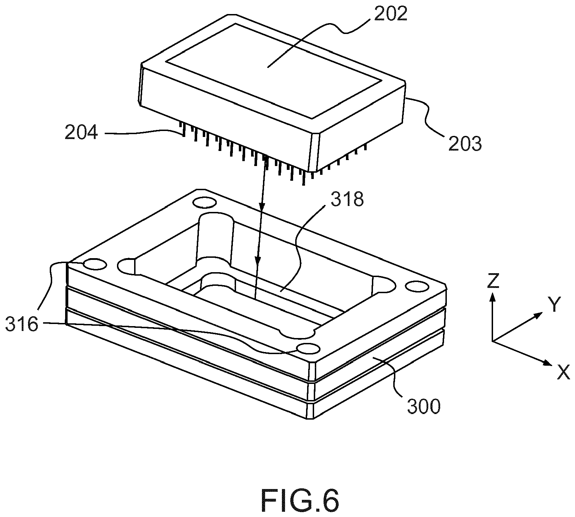

Le cadre est avantageusement constitué d'un matériau thermiquement conducteur tel que l'aluminium ou le cuivre. Avant l'étape de collage, une interface thermique 318 montrée figure 6 est de préférence placée sur la surface de collage 301. Cette interface thermique laisse passer les broches 204 de connexion électrique tout en assurant un bon contact thermique sur la périphérie du capteur. Cette interface thermique permet d'assurer dans un même produit les fonctions de l'échangeur et du radiateur. On utilise typiquement une colle thermiquement conductrice, telle qu'une colle UV qui permet également de fixer le capteur 200 dans le cadre comme indiqué précédemment. En utilisant une résine époxy avec ou sans charges comme colle, la conductivité thermique obtenue est inférieure à 4°C/W entre le capteur 200 et le plan 301 de fixation mécanique.

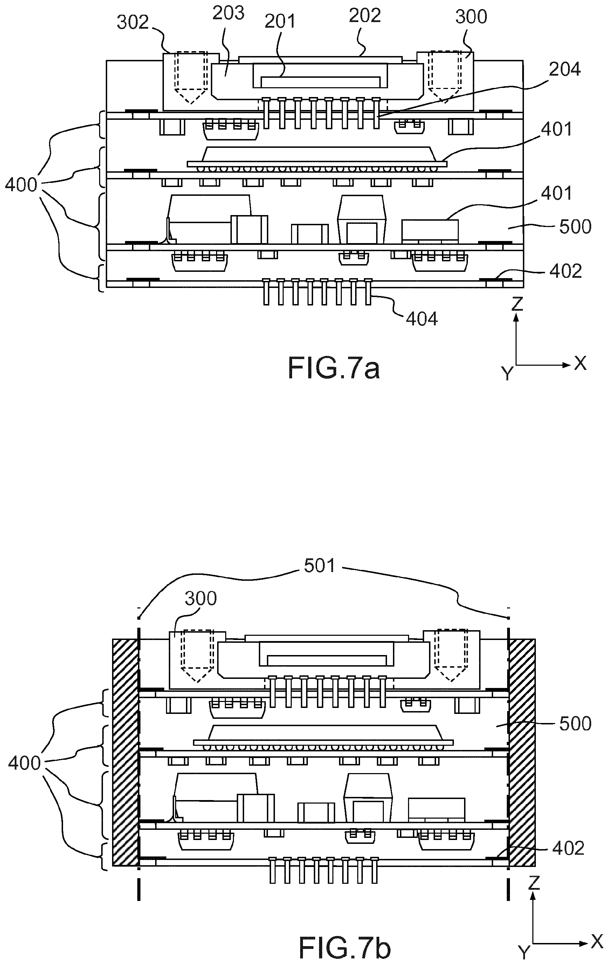

Lorsque le capteur a été fixé au cadre, l'ensemble capteur+cadre est assemblé à un empilement de circuits imprimés 400 comportant chacun un ou plusieurs composants électroniques 401 actifs et/ou passifs sur une face ou sur ses deux faces, comme montré figures 7a, 7b avec un empilement de quatre circuits imprimés 400. Ces composants 401 sont typiquement des composants passifs de filtrage de parasites, de protection du capteur, et des composants actifs tels que des unités de traitement des signaux reçus par la puce, des alimentations.

Une des problématiques des capteurs est d'assurer conjointement la fixation mécanique et la liaison électrique avec ces circuits imprimés. Le raccordement à ces circuits imprimés se fait au travers d'un premier circuit imprimé PCB (acronyme de l'expression anglo-saxonne Printed Cicuit Board) qui comporte des plots de connexion électrique, et éventuellement des composants électroniques. Ce PCB 400 est fixé au cadre 300 et les broches 204 de connexion du capteur 200 sont électriquement reliées aux plots de connexion du PCB par brasure. Par exemple, les broches 204 passent à travers le PCB et sont brasées côté face inférieure du PCB. Le cadre 300 est ainsi pris en sandwich entre le capteur et le PCB. Cet aspect renforce la tenue mécanique et le PCB n'a pas besoin d'être spécifiquement dans le même plan que le capteur 200 ou que la puce 201. Cette implantation permet d'avoir une proximité entre la puce et les composants électroniques de l'empilement, et ceci même en utilisant une interface thermique comme indiqué précédemment. Cette solution permet de réduire de manière importante les bruits électroniques qui entrent en jeu dans la capture d'image.

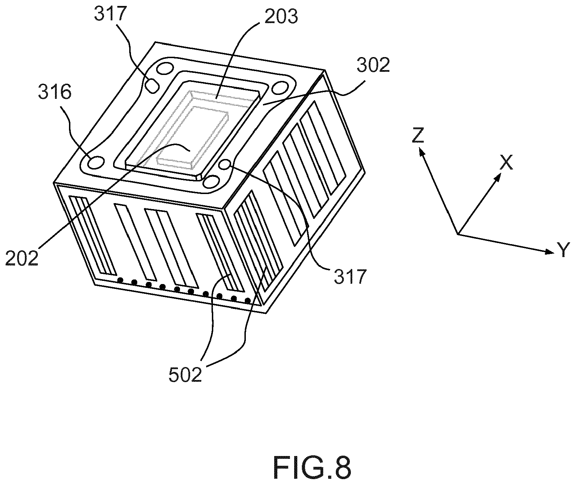

Comme on peut le voir figure 7a, l'ensemble capteur+berceau+empilement est alors moulé dans de la résine 500 jusqu'au plan de référence 302 du berceau ou légèrement en-dessous comme on peut le voir sur la figure ; les dimensions selon XY du cadre sont inférieures à celles de l'empilement comme on peut le voir sur la figure. L'ensemble moulé est alors découpé selon des axes 501 de découpe verticaux (dans l'axe Z) au niveau desquels affleurent des pistes 402 électriquement conductrices de chaque circuit imprimé comme montré figure 7b. Les faces verticales sont alors métallisées et gravées pour réaliser les interconnexions électriques 502 entre les circuits de l'empilement comme montré figure 8. Le dernier circuit imprimé 400 est muni de moyens 404 de connexion électrique externe.

Un tel module dont un exemple est montré figure 8 avec :
- des pistes d'interconnexion 502 sur ses faces latérales,
- le berceau 300 dont on peut voir la face supérieure avec ses taraudages 316 et ses points 317 de référence de fixation d'un dispositif de formation d'images 100,
- le capteur dont on voit la vitre de protection 202, et le boîtier 203, pourra alors être associé à un dispositif 100 de formation d'images en vue d'une application d'imagerie notamment d'imagerie spatiale.

## Revendications

1. Module optoélectronique 3D d'imagerie destiné à être fixé à un dispositif de formation d'images (100) qui comprend :
- un capteur optoélectronique (200) comportant un boîtier (203) dans lequel est logée une puce (201) photosensible à face active plane, avec sur la face opposée des broches (204) de connexion électrique connectées à
- un empilement d'au moins un circuit imprimé (400) équipé de composants électroniques (401),
- l'ensemble capteur (200) et empilement étant moulé dans une résine (500) et présentant des faces verticales selon Z métallisées et gravées pour former des pistes (502) d'interconnexion électrique des circuits imprimés,
**caractérisé en ce qu'**il comprend un berceau rigide thermiquement conducteur sous forme d'un cadre (300) délimitant une ouverture (314) en son centre à travers laquelle passent lesdites broches (204), le cadre présentant une surface de référence selon X,Y et :
∘ sur une surface supérieure (302) :
des points de référence de fixation (317) destinés à centrer et aligner le dispositif de formation d'images par rapport à la surface de référence,
des points de fixation (316) destinés à permettre la fixation du dispositif de formation d'images, et
∘ une surface d'appui intérieure (301) présentant des points d'appui (313) du capteur ajustés pour que la face active de la puce soit centrée et alignée par rapport à la surface de référence.

2. Module optoélectronique 3D selon la revendication précédente, **caractérisé en ce que** la surface de référence est la surface supérieure (302).

3. Module optoélectronique 3D selon la revendication précédente, **caractérisé en ce que** la surface d'appui intérieure (301) est colinéaire de la surface supérieure (302).

4. Module optoélectronique 3D selon la revendication précédente, **caractérisé en ce que** le capteur optoélectronique est celui d'une caméra.

5. Module optoélectronique 3D selon l'une des revendications 3 ou 4, **caractérisé en ce que** la puce (201) comporte 4 millions de pixels.

6. Module optoélectronique 3D selon l'une des revendications 3 ou 4, **caractérisé en ce que** le cadre (300) présente un contour parallépipédique avec sur l'extérieur des cintrages.

7. Procédé de fabrication d'un module optoélectronique 3D d'imagerie selon l'une des revendications précédentes, **caractérisé en ce qu'**il comporte les étapes suivantes :
- positionnement du capteur optoélectronique (200) sur la surface d'appui intérieure (301) de manière à aligner et centrer la face active de la puce (201) par rapport à la surface de référence au moyen des points (313) d'appui du capteur,
- fixation du capteur positionné, par collage,
- assemblage de l'ensemble capteur+cadre à l'empilement de circuits imprimés,
- moulage de l'empilement et du cadre dans de la résine (500) sans dépasser la surface supérieure (302) du cadre,
- découpe selon des axes de découpe (501) pour obtenir des faces latérales,
- métallisation et gravure des faces latérales pour interconnecter électriquement les circuits imprimés.

## Patentansprüche

1. Optoelektronisches Modul zur 3D-Bildanzeige, welches dazu bestimmt ist, an einer Bilderzeugungsvorrichtung (100) befestigt zu werden, Folgendes beinhaltend:
- einen optoelektronischen Sensor (200), welcher ein Gehäuse (203) beinhaltet, in welchem ein lichtempfindlicher Chip (201) mit einer ebenen aktiven Seite untergebracht ist, welcher auf der gegenüberliegenden Seite elektrische Anschlusspins (204) besitzt, welche angeschlossen sind an:
- einen Stapel von mindestens einer Leiterplatte (400), welche mit elektronischen Bauteilen (401) bestückt ist,
- wobei die Baugruppe Sensor (200) und Stapel in einem Harz (500) eingeformt ist und vertikale Seiten entlang Z mit Metallisierung und Gravur zum Bilden der elektrischen (502) Verbindungen der Leiterplatten aufweist,
**dadurch gekennzeichnet, dass** sie ein steifes, wärmeleitfähiges Gestell in Form eines Rahmens (300) beinhaltet, welcher eine Öffnung (314) in seinem Mittelpunkt definiert, durch welche die Pins (204) passieren, wobei der Rahmen eine Referenzfläche entlang X, Y aufweist und:
∘ an einer oberen Fläche (302):
Referenzbefestigungspunkte (317) dazu bestimmt sind, die Bilderzeugungsvorrichtung in Bezug auf die Referenzfläche zu zentrieren und auszufluchten,
Befestigungspunkte (316) dazu bestimmt sind, die Befestigung der Bilderzeugungsvorrichtung zu ermöglichen, und
∘ eine innere Auflagefläche (301) justierte Auflagepunkte (313) des Sensors aufweist, um die aktive Seite des Chips in Bezug auf die Referenzfläche zu zentrieren und auszufluchten.

2. Optoelektronisches 3D-Modul nach dem vorhergehenden Anspruch, **dadurch gekennzeichnet, dass** die Referenzfläche die obere Fläche (302) ist.

3. Optoelektronisches 3D-Modul nach dem vorhergehenden Anspruch, **dadurch gekennzeichnet, dass** die innere Auflagefläche (301) kolinear mit der oberen Fläche (302) ist.

4. Optoelektronisches 3D-Modul nach dem vorhergehenden Anspruch, **dadurch gekennzeichnet, dass** der optoelektronische Sensor derjenige einer Kamera ist.

5. Optoelektronisches 3D-Modul nach einem der Ansprüche 3 oder 4, **dadurch gekennzeichnet, dass** der Chip (201) 4 Millionen Pixel beinhaltet.

6. Optoelektronisches 3D-Modul nach einem der Ansprüche 3 oder 4, **dadurch gekennzeichnet, dass** der Rahmen (300) eine quaderförmige Kontur mit gewölbten Abschnitten an der Außenfläche aufweist.

7. Verfahren zur Herstellung eines optoelektronischen Moduls zur 3D-Bildanzeige nach einem der vorhergehenden Ansprüche, **dadurch gekennzeichnet, dass** es zudem folgende Schritte beinhaltet.
- Positionieren des optolektronischen Sensors (200) auf der inneren Auflagefläche (301) zum Ausfluchten und Zentrieren der aktiven Seite des Chips (201) in Bezug auf die Referenzfläche mithilfe der Auflagepunkte (313) des Sensors,
- Befestigen des positionierten Sensors durch Verkleben,
- Montieren der Baugruppe Sensor + Rahmen an dem Stapel von Leiterplatten,
- Einformen des Stapels und des Rahmens in Harz (500) ohne Überschreiten der oberen Fläche (302) des Rahmens,
- Zuschneiden entlang Zuschnittachsen (501) zum Erzielen von Seitenflächen,
- Metallisieren und Gravieren der Seitenflächen zum elektrischen Verbinden der Leiterplatten.

## Claims

1. 3D imaging optoelectronic module intended to be fixed to an image-forming device (100) which comprises:
- an optoelectronic sensor (200) comprising a package (203) in which is housed a photosensitive chip (201) with planar active face, with, on the opposite face, electrical connection pins (204) connected to
- a stack of at least one printed circuit board (400) equipped with electronic components (401),
- the sensor (200) and stack assembly being moulded in a resin (500) and having vertical faces according to Z metallized and etched to form electrical interconnection tracks (502) of the printed circuit boards,
**characterized in that** it comprises a thermally conductive rigid cradle in the form of a frame (300) delimiting an aperture (314) at its centre through which said pins (204) pass, the frame having a reference surface according to X, Y and:
on a top surface (302):
fixing reference points (317) intended to centre and align the image-forming device in relation to the reference surface,
fixing points (316) intended to allow the fixing of the image-forming device, and
an inner bearing surface (301) having bearing points (313) of the sensor adjusted for the active face of the chip to be centred and aligned in relation to the reference surface.

2. 3D optoelectronic module according to the preceding claim, **characterized in that** the reference surface is the top surface (302).

3. 3D optoelectronic module according to the preceding claim, **characterized in that** the inner bearing surface (301) is collinear to the top surface (302).

4. 3D optoelectronic module according to the preceding claim, **characterized in that** the optoelectronic sensor is that of a camera.

5. 3D optoelectronic module according to one of Claims 3 or 4, **characterized in that** the chip (201) comprises 4 million pixels.

6. 3D optoelectronic module according to one of Claims 3 or 4, **characterized in that** the frame (300) has a parallelepipedal outline dished on the outside.

7. Method for fabricating a 3D imaging optoelectronic module according to one of the preceding claims, **characterized in that** it comprises the following steps:
- positioning the optoelectronic sensor (200) on the inner bearing surface (301) so as to align and centre the active face of the chip (201) in relation to the reference surface by means of the bearing points (313) of the sensor,
- fixing the positioned sensor, by gluing,
- assembling the sensor + frame assembly with the stack of printed circuit boards,
- moulding the stack and the frame in resin (500) without exceeding the top surface (302) of the frame,
- cutting along cutting axes (501) to obtain side faces,
- metallizing and etching the side faces to electrically interconnect the printed circuit boards.
